# EUROPÄISCHE PATENTSCHRIFT

(11) **EP 3 470 681 B1**
(45) Veröffentlichungstag und Bekanntmachung des Hinweises auf die Patenterteilung: **22.09.2021**
(21) Anmeldenummer: 17195789.7
(22) Anmeldetag: 10.10.2017
(51) Int. Cl.: F04D 19/04, F04D 25/06, F04D 29/02, F04D 29/08, H01R 13/52, H01L 21/48, H05K 3/40, H05K 1/14

(54) **ELEKTRISCHE DURCHFÜHRUNG FÜR EIN VAKUUMGERÄT, IN DER FORM EINER DICHTUNGSPLATINE**
ELECTRIC FEEDTHROUGH FOR A VACUUM DEVICE, IN THE FORM OF A PCB
TRAVERSE ÉLECTRIQUE POUR APPAREIL À VIDE, SOUS LA FORME D'UNE PLAQUE DE CIRCUIT IMPRIMÉ

(43) Veröffentlichungstag der Anmeldung: 17.04.2019
(73) Patentinhaber: PFEIFFER VACUUM GMBH, 35614 Asslar (DE)
(72) Erfinder: Stammler, Herbert, 35396 Gießen (DE); Hopf, Dirk, 35641 Schöffengrund-Oberwetz (DE)
(74) Vertreter: Manitz Finsterwald Patent- und Rechtsanwaltspartnerschaft mbB

(56) Entgegenhaltungen:
- EP-A2- 1 843 043
- WO-A1-2014/068848
- JP-A- 2003 254 849
- JP-A- 2005 069 209
- JP-A- 2014 011 120
- US-A1- 2014 322 936

## Beschreibung

Die vorliegende Erfindung betrifft ein Vakuumgerät, insbesondere Vakuumpumpe, umfassend einen Vakuumbereich und einen Druckbereich.

Eine beispielhafte Vakuumpumpe weist im Vakuumbereich einen Antrieb auf, der mittels elektrischer Leitungen mit Strom versorgt wird. Die Leitungen müssen dabei von dem Druckbereich in den Vakuumbereich geführt werden, wobei ein Übergang zwischen Vakuum- und Druckbereich gut abgedichtet sein muss. Das Dokument JP 2014 011120 A offenbart eine Platine, die diesen Zweck erfüllt.

Es ist eine Aufgabe der Erfindung, ein Vakuumgerät der eingangs genannten Art zur Verfügung zu stellen, bei dem ein Vakuumbereich von einem Druckbereich des Vakuumgeräts wirksam abgedichtet ist.

Diese Aufgabe wird durch ein Vakuumgerät gemäß Anspruch 1 gelöst. Das Vakuumgerät umfasst eine Platine, die zwischen dem Vakuumbereich und dem Druckbereich angeordnet ist und zwischen diesen ein Trennelement bildet.

Die Platine trennt den Vakuumbereich von dem Druckbereich und kann dabei als gasdichte Durchführung für Leitungen von dem Druckbereich in den Vakuumbereich dienen.

Erfindungsgemäß bildet die Platine zusammen mit einem Dichtelement eine Dichtung zwischen dem Vakuumbereich und dem Druckbereich, wobei die Platine eine Auflage für das Dichtelement aufweist, welche zumindest eine erste Kupferschicht aufweist. Hierdurch kann eine gute Dichtwirkung erzielt werden, wobei sich die Auflage besonders einfach herstellen lässt, da Kupfer im Allgemeinen für die Ausbildung von Leiterbahnen ohnehin auf der Platine aufgebracht wird. Beispielsweise kann die erste Kupferschicht beim Ätzen von auf der Platine vorgesehenen Leitern bzw. Leiterbahnen mit ausgebildet werden. Es ist also kein zusätzlicher Arbeitsschritt notwendig, um die Auflage für das Dichtelement zu schaffen.

Die Dichtheit zwischen dem Dichtelement und der Auflage wird wesentlich von Form und Größe einer Kontaktfläche zwischen Dichtelement und Auflage bestimmt. Dabei wird ein Abstand zwischen Druck- und Vakuumbereich über die Kontaktfläche auch als Dichtlänge bezeichnet. Eine große Dichtlänge führt im Allgemeinen zu einem großen Widerstand für das abzudichtende Fluid und damit zu einer großen Dichtheit und somit guten Dichtigkeit.

Um eine große Kontakt- bzw. Dichtfläche zu erreichen, kann das Dichtelement beispielsweise elastisch, z.B. als Gummidichtung oder O-Ring, ausgebildet sein. Das Dichtelement kann insbesondere zwischen der Platine, insbesondere der Auflage, und einem Gehäuseelement der Vakuumpumpe komprimiert sein. Dafür kann die Platine beispielsweise mit Schrauben an dem Gehäuseelement und/oder einem mit dem Gehäuseelement verbundenen Element befestigt sein.

Ein vorteilhaftes, als O-Ring ausgebildetes Dichtelement weist einen Querschnittsdurchmesser bzw. eine Schnurstärke von mindestens 1 mm, insbesondere mindestens 1,5 mm, insbesondere mindestens 2 mm auf. Das Dichtelement und/oder die Auflage können z.B. derart ausgebildet sein, dass eine Dichtlänge von mindestens 0,5 mm, insbesondere mindestens 0,7 mm, insbesondere mindestens 0,8 mm, gegeben ist. Der O-Ring kann vorteilhafterweise eine Härte von mindestens 50 Shore-A, insbesondere mindestens 70 Shore-A, und/oder höchstens 100 Shore-A, insbesondere höchstens 80 Shore-A, aufweisen.

Erfindungsgemäß ist die erste Kupferschicht unmittelbar auf ein Trägermaterial der Platine aufgebracht. Als Trägermaterial kann ein für Platinen übliches Material, wie z.B. Epoxidharz mit Glasfasern, verwendet werden. Wenigstens eine Trägerschicht der Platine kann beispielsweise mittels vorimprägnierter Fasermatten hergestellt werden, die auch als Prepregs bezeichnet werden. Alternativ oder zusätzlich kann wenigstens eine Trägerschicht ein FR4-Material umfassen.

Erfindungsgemäß ist auch vorgesehen, dass die Auflage zumindest eine zweite Kupferschicht aufweist, welche elektrolytisch oder galvanisch auf die erste Kupferschicht aufgebracht ist.

Eine weitere Ausführungsform sieht vor, dass zumindest eine Schicht der Auflage, insbesondere an einer Verbindungsfläche zu einer weiteren Schicht oder einer Auflagefläche für das Dichtelement, insbesondere mechanisch, geebnet und/oder geglättet ist. Hierdurch kann die Dichtwirkung verbessert werden. Die Auflage kann hierfür beispielsweise mittels Bürsten, z.B. mit Glasfasern, Schleifen, z.B. mit Bimsmehl, oder auch chemisch, z.B. elektrolytisch und/oder mit einem Plasma bearbeitet oder behandelt werden. Die Bearbeitung bzw. Behandlung dient dabei vorteilhafterweise dazu, die höchsten Erhebungen einer Oberfläche der Auflage abzutragen bzw. einzuebnen. Dabei spielt eine Rauigkeit der Oberfläche insbesondere keine oder nur eine untergeordnete Rolle. Es hat sich gezeigt, dass vor allem lokale Erhebungen zu Fehlern in einer Verbindung zu einer auf die bearbeitete Fläche aufgetragenen Schicht führen. Dagegen werden Niederungen und unterschiedliche Rauigkeiten der unteren Schicht meist zuverlässig verfüllt und mit der oberen Schicht verbunden. Daher kann insbesondere eine Ebnung von Erhebungen der unteren Schicht vorgesehen sein.

Allgemein kann durch die Wahl eines Beschichtungsverfahrens für die Auflage und einer Beschichtungsgüte eine Optimierung der Oberfläche der jeweiligen Schicht erreicht werden. Beispielsweise kann eine Schicht, insbesondere Kupferschicht, auch besonders fein und/oder dünn, z.B. als Feinstkupferschicht, aufgebracht werden. Somit wird eine geringe Korngröße im Schichtmaterial ausgebildet, was zu einer besonders gleichmäßigen und ebenen Oberfläche führt.

Die Auflage kann gemäß einer Weiterbildung zumindest eine Nickelschicht, insbesondere mit einer Dicke von mindestens 2 µm, insbesondere mindestens 4 µm, insbesondere mindestens 8 µm und/oder höchstens 10 µm,insbesondere höchstens 8 µm,insbesondere höchstens 6 µm aufweisen. Hierdurch lassen sich insbesondere vorteilhaft verschiedene Schichten der Auflage verbinden und verbliebene Unebenheiten der darunter liegenden Schicht ausgleichen.

Insbesondere kann eine Auflagefläche für das Dichtelement von einer Goldschicht, insbesondere mit einer Dicke von mindestens 0,03 µm,insbesondere mindestens 0,05 µm,insbesondere mindestens 0,1 µm und/oder höchstens 0,15 µm,insbesondere höchstens 0,12 µm,insbesondere höchstens 0,1 µm gebildet sein. Eine solche erlaubt eine hohe Oberflächengüte und damit eine gute oder optimale Abdichtung. Außerdem wird durch Gold als Edelmetall eine Korrosion im Bereich der Dichtung vermieden und so die Lebensdauer der Dichtung verlängert.

Gemäß einer Weiterbildung weist die Platine eine innenliegende Durchkontaktierung auf, welche, insbesondere zumindest im Wesentlichen vollständig, verfüllt ist. Die Durchkontaktierung weist dabei beispielsweise eine Bohrung auf, die verfüllt ist.

Die Durchkontaktierung kann beispielsweise zur Verbesserung der Dichtwirkung mit einem Kunststoffmaterial, z.B. Epoxidharz, insbesondere einem Material einer der Durchkontaktierung benachbarten Platinenschicht, verfüllt sein. Insbesondere kann die Verfüllung zusammen mit der benachbarten Platinenschicht hergestellt sein und/oder mit dieser einstückig verbunden oder ausgebildet sein. Somit kann ein einfaches Herstellungsverfahren bei guter Dichtwirkung der Platine realisiert werden.

Es kann vorgesehen sein, dass das Kunststoffmaterial unter erhöhtem Druck und/oder erhöhter Temperatur in die Durchkontaktierung eingebracht worden ist. Hierdurch kann ein besonders guter Verfüllungsgrad, also eine zumindest im Wesentlichen vollständige Verfüllung, erreicht werden.

Bei einer weiteren Ausführungsform umfasst die Durchkontaktierung einen ersten Leiter, einen zweiten Leiter und eine die Leiter verbindende Bohrung, welche zumindest den zweiten Leiter nicht oder nicht vollständig durchdringt. Hierdurch kann ein Querschnitt des zweiten Leiters zumindest teilweise, vorzugsweise möglichst vollständig, erhalten bleiben, wodurch die Leitfähigkeit des zweiten Leiters im Wesentlichen erhalten bleibt bzw. der Leitungswiderstand am Ort der Bohrung niedrig gehalten wird. Dies kann beispielsweise dann besonders vorteilhaft sein, wenn der zweite Leiter zur Leitung relativ großer Ströme vorgesehen ist, insbesondere wenn die Durchkontaktierung und der erste Leiter nur Messabgriff von dem zweiten Leiter als Messwert dienen und der erste Leiter entsprechend nur Spannungen bzw. geringe Ströme führt. Alternativ kann eine Bohrung einer Durchkontaktierung zwei zu kontaktierende Leiter vollständig durchdringen.

Gemäß einer Weiterbildung weist die Platine zumindest zwei, vorzugsweise drei oder mehr als zwei voneinander unabhängige Dichtbereiche jeweils mit einer Auflage und einem Dichtelement auf. Diese Dichtbereiche können zumindest teilweise mit identischen oder unterschiedlichen Abmessungen, insbesondere von Auflage und/oder Dichtelement, und/oder in verschiedenen Teilbereichen der Platine angeordnet sein, z.B. um verschiedene elektrische Funktionsgruppen beabstandet zu kontaktieren bzw. anzuordnen. Zwischen den Dichtbereichen können Mindestabstände, inbesondere zur Reduzierung von gegenseitiger elektromagnetischer Beeinflussung, z.B. Streufeldern, oder auch zur Einhaltung von Sicherheitsabständen von Hochspannung führenden Bau- oder Funktionsgruppen zu anderen vorgesehen sein. Typische Bau- oder Funktionsgruppen können zum Beispiel drei oder mehr Antriebsleitungen, z.B. für unterschiedliche Motorphasen, und/oder Sensorikleitungen, z.B. für Temperatur- und/oder Drehpositionsgeber, oder auch Aktorik- und/oder Sensorikleitungen für Komponenten eines Aktivmagnetlagersystems sein.

Eine weitere Ausführungsform sieht eine Platine vor, die mehrere mechanisch unabhängige und/oder zueinander flexibel ausgeführte Teilbereiche umfasst, die z.B. durch flexible Leiter und/oder federnd ausgeführte Verbindungsstege elektrisch miteinander verbunden sind. Beispielsweise kann zumindest ein, insbesondere jeder, Teilbereich einen Dichtbereich aufweisen. Weitere Dichtbereiche können gemeinsam auf einem und/oder auf mehreren Teilbereichen getrennt angeordnet sein. Eine Flexibilität der Teilbereiche der Platine untereinander ermöglicht eine bessere Anpassung an ein oder mehrere Gehäuseelemente, an denen die Dichtbereiche angeordnet sein können. Verschiedene Teilbereiche der Platine müssen nicht in einer Ebene liegen, sondern können zueinander versetzt und/oder in einer anderen Orientierung, beispielsweise abgewinkelt, ausgerichtet und/oder zum Beispiel um ein Gehäuse herum oder an einer anderen Gehäuseseite angeordnet werden. Eine Verbindung zwischen Teilbereichen der Platine erfolgt zum Beispiel durch flexible Leiterbahnen oder Kabelbrücken, die zum Beispiel an die Teilbereiche gesteckt, gelötet, geschweißt und/oder geklebt sein können. Alternativ kann die Platine selbst durch Ausnehmungen, zum Beispiel durch mäanderförmig ausgeführte Verbindungsbereiche zwischen den Teilbereichen so flexibel gestaltet werden, dass sie eine ausreichend mechanisch biegeweiche elektrische Verbindungsstelle darstellt.

Die Dichtheit der Platine insgesamt wird auch durch eine Dichtheit entlang einzelner Leiter innerhalb der Platine, also innenliegender Leiter, bestimmt. Diese Dichtheit wird maßgeblich durch Länge und Querschnitt von sich zwischen einer benachbarten oder überdeckenden Trägerschicht und dem Leiter ausbildenden Spalten oder Freiräumen bestimmt. Um die Dichtheit entlang eines innenliegenden Leiters zu erhöhen, kann es vorgesehen sein, dass der Leiter von benachbarten Trägerschichten der Platine möglichst vollständig umschlossen ist. Insbesondere sollte also das Trägermaterial so, beispielsweise unter erhöhter Temperatur und/oder erhöhtem Druck, aufgebracht werden, dass es den Leiter möglichst vollständig einhüllt und möglichst keine oder kleine Spalte belässt. Auch in Bereichen zwischen Trägerschichten ohne Leiter gilt es, keine oder nur möglichst kleine Spalte zu belassen, da ein abzudichtendes Fluid, z.B. Prozessgas einer Vakuumpumpe, nicht an einen Pfad in der Platine gebunden ist.

Als problematisch hinsichtlich der Dichtheit entlang eines innenliegenden, also zwischen zwei Trägerschichten befindlichen, Leiters kann es sich erweisen, wenn der Leiter, wie es üblich ist, aus einer mit Kupfer beschichteten ersten Trägerschicht geätzt ist. Dabei kann sich an einem Grund des Leiters seitlich entlang des Leiters eine Hinterschneidung ausbilden. Eine derartige Hinterschneidung ist beim Aufbringen einer zweiten Trägerschicht über dem Leiter durch dessen Material, wie Epoxidharz, nur schwierig zu verfüllen. Eine Hinterschneidung lässt sich insbesondere durch erhöhte Temperatur bzw. erhöhten Druck beim Aufbringen besser verfüllen.

Eine Gesamtdichtheit der Platine bestimmt sich aus allen lokalen Dichtheiten entlang eines abzudichtenden Fluidpfades durch die Platine. Die Gesamtdichtheit kann durch eine optimale Abstimmung und Anordnung von Einzeldichtheiten erhöht werden. Beispielsweise kann ein Bereich, in dem aus fertigungstechnischen Gründen ein relativ großer Durchtrittsquerschnitt für das Fluid erwartet wird, besonders lang ausgebildet werden, damit dieser Bereich insgesamt dennoch eine akzeptable Dichtigkeit aufweist. Leicht abzudichtende Bereiche können hingegen relativ kurz ausgebildet sein, beispielsweise um Bauraum zu sparen.

Bei einer Weiterbildung der Erfindung weist die Platine zumindest zwei Trägerschichten auf, wobei zwischen den Trägerschichten eine zusätzliche Dichtung vorgesehen ist. Der Begriff "zusätzlich" bezieht sich hier darauf, dass zwei flächig aufeinanderliegende Trägerschichten selbst eine Dichtung bilden. Bei dieser Weiterbildung ist also hierüber hinaus noch eine weitere Dichtung vorgesehen.

Die zusätzliche Dichtung kann beispielsweise als ein, insbesondere nicht beschalteter, Leiter ausgebildet sein. Ein solcher ist besonders einfach herstellbar, beispielsweise beim ohnehin durchgeführten Ätzen von weiteren, beschalteten Leitern.

Beispielsweise kann es vorgesehen sein, dass die zusätzliche Dichtung einen abzudichtenden Bereich teilweise oder vollständig umschließt. Hierdurch kann vorteilhaft ausgenutzt werden, dass eine Dichtung, insbesondere ein Leiter, zwischen zwei Trägerschichten typischerweise besonders quer zu einer Erstreckungsrichtung der Dichtung gut abdichtbar ist.

Die zusätzliche Dichtung kann beispielsweise auch als Randdichtung ausgebildet sein oder eine solche umfassen.

Eine weitere vorteilhafte Ausführungsform sieht vor, dass die Platine eine Kavität, insbesondere zur Anordnung elektronischer Komponenten, aufweist, wobei insbesondere die Kavität einen abzudichtenden Bereich bildet. Die Kavität lässt sich also insbesondere durch eine vorstehend beschriebene zusätzliche Dichtung, insbesondere einen die Kavität zumindest teilweise umschließenden Leiter, abdichten.

Die Kavität kann beispielsweise einen Hohlraum bilden oder zumindest teilweise verfüllt sein. Im letzteren Fall kann die Kavität beispielsweise nur während einer Herstellung der Platine zwischenzeitlich für eine elektronische Komponente vorgesehen sein, später jedoch, insbesondere durch ein Trägermaterial der Platine, verfüllt werden.

Ein innenliegender Leiter kann zur weiteren Verbesserung der Dichtheit beispielsweise besonders lang und/oder komplex ausgebildet sein. Hierdurch wird ein Fluidpfad entlang des Leiters entsprechend verlängert und es stellt sich eine relativ hohe Dichtheit bzw. ein relativ hoher Widerstand für das Fluid ein. Beispielsweise kann der Leiter eine labyrinthartige und/oder mäandernde Struktur aufweisen.

Die Platine kann beispielsweise wenigstens eine Befestigungsausnehmung, insbesondere Befestigungsbohrung, aufweisen, mittels derer die Platine an einem Gegenelement, insbesondere Gehäuse der Vakuumpumpe, beispielsweise mittels eines Befestigungselementes, z.B. einer Schraube, befestigt ist. Die Befestigungsausnehmung kann zum Beispiel einen elektrischen Kontakt für ein Befestigungselement aufweisen, insbesondere einen Masse- bzw. Erdungskontakt. Alternativ oder zusätzlich kann die Befestigungsausnehmung für diesen Zweck eine Durchkontaktierung aufweisen.

Gemäß einer Weiterbildung kann eine Befestigung der Platine an einem Gegenelement durch das flächige Einspannen und/oder Andrücken mit einem Druckelement erfolgen, das z.B. seinerseits entweder mit zumindest einem Befestigungselement, z.B. einer Schraube, durch ein Durchgangsloch durch die Platine hindurch und/oder mit zumindest einem Befestigungselement außerhalb der Platine mit dem Gegenelement verspannt ist. Ein solches Druckelement kann, wie auch die Platine, Ausnehmungen außerhalb und/oder Erhebungen im Bereich eines darunter liegenden Dichtbereichs aufweisen, die insbesondere eine definierte, gleichmäßige und/oder bestmögliche Anpressung der Platine mit einer Auflagefläche und einer Dichtung auf einem Gegenelement, z.B. einem Gehäuse der Vakuumpumpe, sicherstellen. Ein Druckelement kann auch zusätzliche Aufgaben wie z.B. das Abdecken eines der Platine umliegenden Bereiches des Gegenelements oder auch ein zusätzliches Abdichten von Öffnungen des Gegenelements in diesen Bereichen unabhängig von der Platine, insbesondere mit einem separaten Dichtelement, erfüllen.

Bei einer weiteren Ausführungsform weist die Platine wenigstens zwei Trägerschichten auf, zwischen denen wenigstens ein Leiter vorgesehen ist, wobei zwischen den Trägerschichten zum Ausgleich von Unebenheiten in der Platine zumindest eine Ausgleichsschicht vorgesehen ist.

Bei einem beispielhaften Herstellungsverfahren für eine Platine werden mehrere Leiterbahnen zwischen zwei oder mehreren Trägerschichten eingebettet. Während dieses Vorgangs, also vor Aushärten der Trägerschichten, weist die Platine eine relativ große Flexibilität auf. Je dicker bzw. höher die Leiterbahnen ausgeführt werden und/oder je mehr Leiterbahnen sich auf verschiedenen Ebenen kreuzen bzw. überlagern, desto unebener kann die resultierende Platine werden. Um solche Unebenheiten bzw. Welligkeiten möglichst auszuschließen oder zu minimieren, können in Ausgleichsbereichen, z.B. im Bereich einer Auflage für ein Dichtelement und/oder im Bereich einer Befestigungsausnehmung, zwischen allen oder ausgewählten Schichten Blindleiterbahnen oder -flächen angeordnet werden, die einen nicht von Leiterbahnen belegten Bereich, insbesondere mit geringen, ausreichend isolierenden Abständen zu den Leiterbahnen, derart überdecken, dass eine gleichmäßige Materialdicke zumindest über einen Teilbereich der Platine erreicht wird.

Eine zur Isolation zwischen zwei Leitern notwendige Unterbrechung ist grundsätzlich relativ klein im Vergleich zu der Gesamtfläche der Platine. Optional können Blindleiterbahnen oder -flächen durch einen elektrischen Anschluss und/oder eine Durchkontaktierung auch auf ein bestimmtes Potential gebracht werden, z.B. Masse bzw. Erde, z.B. zwecks Schirmung. Grundsätzlich können Blindleiterbahnen oder -flächen, die mit beschalteten Leiterbahnen eine gemeinsame, sich zu einer im Wesentlichen ebenen Fläche vereinende Kontur aufweisen, auch auf verschiedenen Ebenen, also zwischen unterschiedlichen Trägerschichten, untergebracht sein. Die Trägerschichten formen sich dann entsprechend an die Form der Leiterbahnen an. Maßgeblich für die Ebenheit der Platine ist vor allem die effektive Gesamthöhe der Schichtenstapel auf zumindest einem überwiegenden Teil der Platine.

Die Ausgleichsschicht kann beispielsweise als, insbesondere nicht beschalteter, Leiter ausgebildet sein. Die Ausgleichsschicht kann insbesondere gleichzeitig als zusätzliche Dichtung im oben beschriebenen Sinne ausgebildet sein. Durch Hinzufügen und Gestalten, insbesondere nicht beschalteter, Leiter lässt sich somit die Platine wirksam hinsichtlich Dichtheit optimieren, während sich solche Leiter besonders einfach, insbesondere beim ohnehin vorgesehenen Ätzen, herstellen lassen.

Grundsätzlich kann ein Leiter der Platine z.B. als Leiterbahn und/oder als Leiterfläche o.Ä. ausgebildet sein. Je nach Bedarf können Leiterbahnen und Durchkontaktierungen mit unterschiedlichen Höhen bzw. Querschnitten hergestellt werden. Vorteilhafterweise weist ein Leiter eine Dicke von mindestens 30 µm,insbesondere mindestens oder etwa 70 µm,insbesondere mindestens 100 µm, und/oder höchstens 300 µm, insbesondere von etwa 210 µm, auf.

Durchkontaktierungen werden typischerweise durch nachträglich galvanisch oder elektrolytisch aufgebrachtes Kupfer hergestellt. Dabei schlägt sich Kupfer nicht nur in einer Bohrung für die Durchkontaktierung, sondern auch auf allen angrenzenden freiliegenden Kupferoberflächen bzw. -leiterbahnen nieder. Hierdurch entsteht ein Gesamtquerschnitt bzw. eine Höhe des betreffenden Leiters. Die Höhe des Leiters ergibt sich also aus der Höhe einer beim Ätzen ausgebildeten Kupfergrundschicht und der Höhe des zusätzlich aufgetragenen Kupfers. Diese Parameter lassen sich kleinschrittig frei kombinieren, um damit gezielt die Ebenheit der Platine und die Gesamtquerschnitte der Leiterbahnen und Durchkontaktierungen zu bestimmen.

Durchkontaktierungen müssen grundsätzlich vollständig fertiggestellt, also gebohrt und mit Kupfer beschichtet, sein, bevor eine weitere Trägerschicht auf die Platine aufgebracht wird. Andere Bereiche der Platine weisen keine zuvor herzustellenden Durchkontaktierungen auf. Eine weitere Trägerschicht kann dort direkt auf geätzte Leiter aufgebracht werden. Die Höhe eines Leiters bestimmt sich hier lediglich durch die beim Ätzen ausgebildete Höhe. Dies stellt letztlich den Standardfall für einfache Platinen dar.

Bei einer weiteren Ausführungsform ist vorgesehen, dass in der Platine wenigstens zwei funktional parallele Fluidpfade vorhanden sind, die zumindest teilweise entlang innenliegender Leiter in der Platine verlaufen, wobei die zwei Fluidpfade wenigstens annähernd gleiche Teildichtigkeiten aufweisen. Hierdurch wird sichergestellt, dass ein Gas aus dem Druckbereich nicht über einen weniger dichten der Fluidpfade vermehrt in den Vakuumbereich strömt.

Des Weiteren wird auch ein Verfahren zur Optimierung der Gesamtdichtigkeit einer Platine eines Vakuumgeräts zur Trennung eines Vakuumbereichs von einem Druckbereich bereitgestellt, bei dem wenigstens bei zwei funktional parallel verlaufenden Fluidpfaden in der Platine, die zumindest teilweise entlang innenliegender Leiter in der Platine verlaufen, wenigstens annähernd gleiche Teildichtigkeiten vorgesehen werden.

Die Erfindung und weitere Ausführungsbeispiele werden nachfolgend lediglich beispielhaft anhand der schematischen Zeichnung erläutert.
- Fig. 1: zeigt eine Vakuumpumpe in einer Schnittansicht.
- Fig. 2: zeigt eine Platine eines Vakuumgerätes, welche als Trennelement zum Trennen eines Vakuumbereichs von einem Druckbereich ausgebildet ist.
- Fig. 3: zeigt die Platine der Fig. 2 in einer Schnittdarstellung.
- Fig. 4: zeigt eine Auflage für ein Dichtelement in einer Schnittdarstellung gemäß der Erfindung.
- Fig. 5: zeigt eine weitere, als Trennelement ausgebildete Platine in einer Schnittdarstellung.
- Fig. 6: zeigt einen innenliegenden Leiter einer Platine.
- Fig. 7: zeigt eine innenliegende Durchkontaktierung einer Platine.
- Fig. 8: zeigt eine weitere, als Trennelement ausgebildete Platine.
- Fig. 9: zeigt die Platine der Fig. 8 in einer Schnittdarstellung.
- Fig. 10: zeigt ein Vakuumgerät mit einer Platine, welche als Trennelement zum Trennen eines Vakuumbereichs von einem Druckbereich ausgebildet ist.

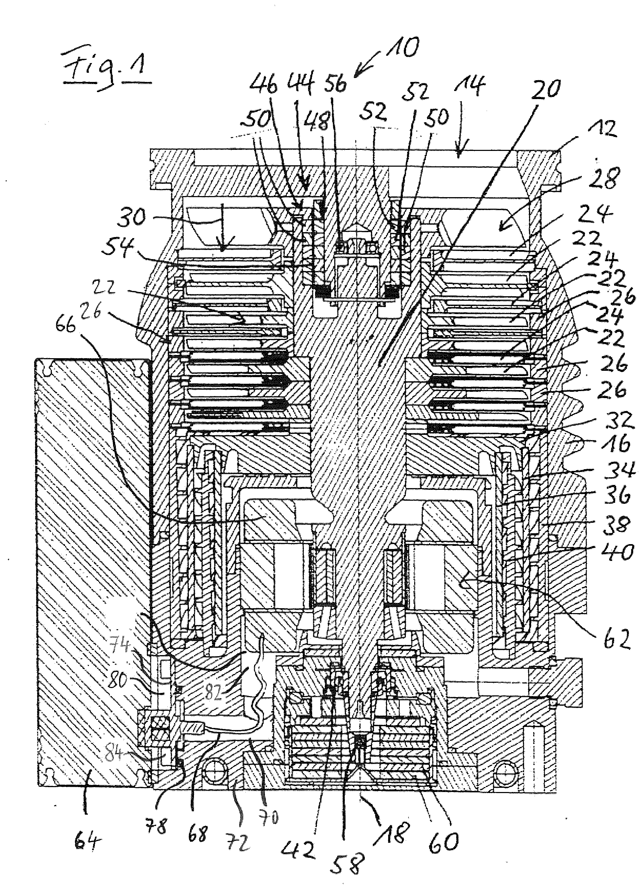

Die in Fig. 1 gezeigte Vakuumpumpe 10 umfasst einen von einem Einlassflansch 12 umgebenen Pumpeneinlass 14 sowie mehrere Pumpstufen zur Förderung des an dem Pumpeneinlass 14 anstehenden Gases zu einem in Fig. 1 nicht dargestellten Pumpenauslass. Die Vakuumpumpe 10 umfasst einen Stator mit einem statischen Gehäuse 16 und einen in dem Gehäuse 16 angeordneten Rotor mit einer um eine Rotorachse bzw. Rotationsachse 18 drehbar gelagerten Rotorwelle 20.

Die Vakuumpumpe 10 ist als Turbomolekularpumpe ausgebildet und umfasst mehrere pumpwirksam miteinander in Serie geschaltete turbomolekulare Pumpstufen mit mehreren mit der Rotorwelle 20 verbundenen turbomolekularen Rotorscheiben 22 und mehreren in axialer Richtung zwischen den Rotorscheiben 22 angeordneten und in dem Gehäuse 16 festgelegten turbomolekularen Statorscheiben 24, die durch Distanzringe 26 in einem gewünschten axialen Abstand zueinander gehalten sind. Die Rotorscheiben 22 und Statorscheiben 24 stellen in einem Schöpfbereich 28 eine in Richtung des Pfeils 30 gerichtete axiale Pumpwirkung bereit.

Die Vakuumpumpe 10 umfasst zudem drei in radialer Richtung ineinander angeordnete und pumpwirksam miteinander in Serie geschaltete Holweck-Pumpstufen. Der rotorseitige Teil der Holweck-Pumpstufen umfasst eine mit der Rotorwelle 20 verbundene Rotornabe 32 und zwei an der Rotornabe 32 befestigte und von dieser getragene zylindermantelförmige Holweck-Rotorhülsen 34, 36, die koaxial zu der Rotorachse 18 orientiert und in radialer Richtung ineinander geschachtelt sind. Ferner sind zwei zylindermantelförmige Holweck-Statorhülsen 38, 40 vorgesehen, die ebenfalls koaxial zu der Rotationsachse 18 orientiert und in radialer Richtung ineinander geschachtelt sind. Die pumpaktiven Oberflächen der Holweck-Pumpstufen sind jeweils durch die einander unter Ausbildung eines engen radialen Holweck-Spalts gegenüberliegenden radialen Mantelflächen jeweils einer Holweck-Rotorhülse 34, 36 und einer Holweck-Statorhülse 38, 40 gebildet. Dabei ist jeweils eine der pumpaktiven Oberflächen glatt ausgebildet, im vorliegenden Fall die der Holweck-Rotorhülse 34 bzw. 36, und die gegenüberliegende pumpaktive Oberfläche der Holweck-Statorhülse 38, 40 weist eine Strukturierung mit schraubenlinienförmig um die Rotationsachse 18 herum in axialer Richtung verlaufenden Nuten auf, in denen durch die Rotation des Rotors das Gas vorangetrieben und dadurch gepumpt wird.

Die drehbare Lagerung der Rotorwelle 20 wird durch ein Wälzlager 42 im Bereich des Pumpenauslasses und ein Permanentmagnetlager 44 im Bereich des Pumpeneinlasses 14 bewirkt.

Das Permanentmagnetlager 44 umfasst eine rotorseitige Lagerhälfte 46 und eine statorseitige Lagerhälfte 48, die jeweils einen Ringstapel aus mehreren in axialer Richtung aufeinandergestapelten permanentmagnetischen Ringen 50, 52 umfassen, wobei die Magnetringe 50, 52 unter Ausbildung eines radialen Lagerspalts 54 einander gegenüberliegen.

Innerhalb des Permanentmagnetlagers 44 ist ein Not- oder Fanglager 56 vorgesehen, das als ungeschmiertes Wälzlager ausgebildet ist und im normalen Betrieb der Vakuumpumpe ohne Berührung leer läuft und erst bei einer übermäßigen radialen Auslenkung des Rotors gegenüber dem Stator in Eingriff gelangt, um einen radialen Anschlag für den Rotor zu bilden, der eine Kollision der rotorseitigen Strukturen mit den statorseitigen Strukturen verhindert.

In Bereich des Wälzlagers 42 ist an der Rotorwelle 20 eine konische Spritzmutter 58 mit einem zu dem Wälzlager 42 hin zunehmenden Außendurchmesser vorgesehen, die mit einem Abstreifer eines mehrere mit einem Betriebsmittel, wie zum Beispiel einem Schmiermittel, getränkte saugfähige Scheiben 60 umfassenden Betriebsmittelspeichers in gleitendem Kontakt steht. Im Betrieb wird das Betriebsmittel durch kapillare Wirkung von dem Betriebsmittelspeicher über den Abstreifer auf die rotierende Spritzmutter 58 übertragen und infolge der Zentrifugalkraft entlang der Spritzmutter 58 in Richtung des größer werdenden Außendurchmessers der Spritzmutter 58 zu dem Wälzlager 42 hin gefördert, wo es zum Beispiel eine schmierende Funktion erfüllt.

Die turbomolekularen Pumpstufen stellen in dem Schöpfbereich 28 eine Pumpwirkung in Richtung des Pfeils 30 bereit.

Die Vakuumpumpe 10 umfasst einen Antriebsmotor 62 zum drehenden Antreiben des Rotors, dessen Läufer bzw. Rotor durch die Rotorwelle 20 gebildet ist. Eine Steuerungseinheit 64 steuert den Antriebsmotor 62 an.

Der Antriebsmotor 62 weist ferner einen Motorstator 66 bzw. Ständer auf. Der Motorstator 66 ist mit der Steuerungseinheit 64 über einen Leiter 68 verbunden. Der Leiter 68 entspringt innerhalb des Motorstators 66, tritt aus diesem an einem Austrittsbereich aus und verläuft von dort aus durch einen Gang 70, welcher in einem Gehäuseteil 72 der Vakuumpumpe ausgebildet ist, zu einer mit der Steuerungseinheit 64 verbundenen Platine 74. Der Leiter 68 ist in dem Gang 70 im Wesentlichen freiliegend verlegt.

Der Gang 70 ist Teil eines Vakuumbereichs 82 der Vakuumpumpe 10 und gegenüber einem Druckbereich 80, in dem im Wesentlichen atmosphärischer Druck herrscht, durch die Platine 74 getrennt. Die Platine 74 ist mittels Schrauben 84 an dem Gehäuseteil 72 befestigt und komprimiert einen O-Ring 78 zur Abdichtung des Vakuumbereichs 82 von dem Druckbereich 80.

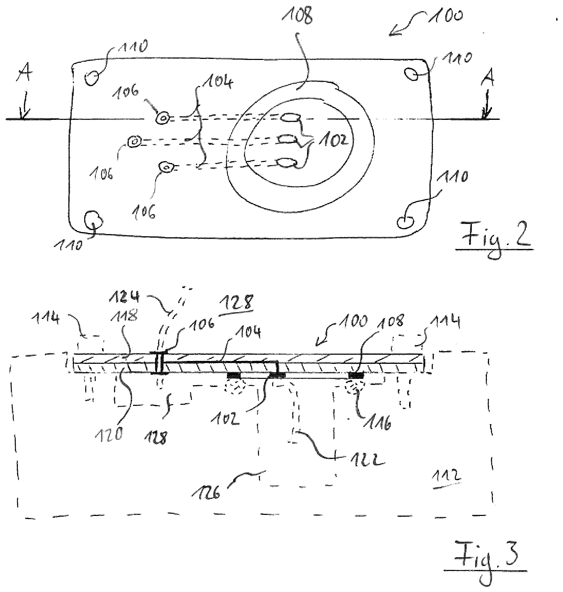

In Fig. 2 ist eine Platine 100 gezeigt, die als Trennelement zwischen einem Vakuumbereich und einem Druckbereich eines Vakuumgeräts wie z.B. der vorstehend in Verbindung mit Fig. 1 beschriebenen Vakuumpumpe 10 verwendet werden kann. Die Platine 100 umfasst drei dem Betrachter zugewandte Kontaktpunkte 102, die jeweils über einen innen in der Platine 100 liegenden und daher gestrichelt angedeuteten Leiter 104 mit einem als Durchkontaktierung ausgebildeten Kontaktpunkt 106 verbunden sind.

Um die Kontaktpunkte 102 ringförmig herum erstreckt sich eine Auflage 108 für ein Dichtelement. Die, insbesondere ebene, Form der Auflage 108 und/oder des Dichtelements beschreibt beispielsweise einen geschlossenen Ring, bevorzugt einen Kreisring. Die Form kann jedoch beispielsweise auch eine beliebig komplexe Form oder Geometrie aufweisen. Zum Beispiel seien hier ein an den Ecken abgerundetes Quadrat oder allgemein ein beliebiges Polygon mit oder ohne Bogensegmenten statt Ecken als Grundformen genannt. Bei Nutzung komplexer Dichtelemente, zum Beispiel einer Formdichtung mit mehr als einem Dichtbereich (Details siehe EP3135917A1), kann die Auflagefläche entsprechend aus mehreren verschiedenen, zusammengesetzten Geometrieelementen bestehen. Die Platine 100 umfasst außerdem mehrere als Bohrungen 110 ausgebildete Befestigungsausnehmungen. Bevorzugt sind zumindest einige der Befestigungsausnehmungen so um die Auflagefläche herum angeordnet, dass sie in einem zumindest überwiegend gleichmäßigen Abstand zueinander und zur Auflagefläche stehen, z.B. um bei der Befestigung der Platine eine bestmögliche, gleichmäßig verteilte Verpressung der Auflage mit dem Dichtelement zu ermöglichen.

In Fig. 3 ist die Platine 100 der Fig. 2 in einer geschnittenen Ansicht gezeigt, wobei die Schnittebene in Fig. 2 durch A-A angedeutet ist. In Fig. 3 ist außerdem gestrichelt angedeutet, wie die Platine 100 an einem Gehäuse 112 eines Vakuumgeräts befestigt ist. Dies erfolgt mittels Schrauben 114, die die Platine 100 gegen das Gehäuse 112 spannen, wobei zwischen der Auflage 108 und dem Gehäuse 112 ein als O-Ring 116 ausgebildetes Dichtelement komprimiert wird. Alternativ kann ein Druckelement zwischen den Schrauben 114 und der Platine 100 angeordnet sein, das die Gleichmäßigkeit der Anpressung der Platine 100 und damit der Auflage 108 und des O-Rings 116 an das Gehäuse 112 über den Umfang der Auflage verbessert. Vorteilhaft hat das Druckelement oder die Platine im Bereich der Auflage Vorsprünge, z.B. durch zusätzliche Leiterbahnen auf oder zwischen den Trägerschichten, oder außerhalb des Bereiches Ausnehmungen, die die Anpresskräfte der Schrauben 114 vornehmlich auf den Bereich der Auflage 108 konzentrieren.

Die Platine 100 ist elektrisch dreilagig ausgeführt und umfasst zwei Trägerschichten 118 und 120. Der Leiter 104, welcher die Kontaktpunkte 102 und 106 miteinander verbindet, verläuft dabei zwischen den Trägerschichten 118 und 120, ist also innenliegend ausgebildet. Für beide Kontaktpunkte 102 und 106 ist ein Anschlussleiter 122 bzw. 124 zum Beispiel zum Anschluss eines Antriebs einerseits und einer Steuerung andererseits vorgesehen.

In dem Gehäuse 112 des Vakuumgeräts ist ein Vakuumbereich 126 definiert, in dem sich der Kontaktpunkt 102 der Platine 100 befindet. Der Anschlussleiter 122 ist also in den Vakuumbereich 126 hinein verlegt und dient der Anbindung einer in dem Vakuumbereich befindlichen elektrischen Komponente, wie zum Beispiel einem Antriebsmotor für eine Vakuumpumpe. Der Kontaktpunkt 106 ist in einem Druckbereich 128 angeordnet, und zwar sowohl mit seiner dem Gehäuse 112 zugewandten Seite als auch mit seiner dem Gehäuse 112 abgewandten Seite. Der Vakuumbereich 126 ist von dem Druckbereich 128 durch die Trägerschichten 118 und 120 und durch den O-Ring 116 in Verbindung mit der Auflage 108 getrennt bzw. abgedichtet.

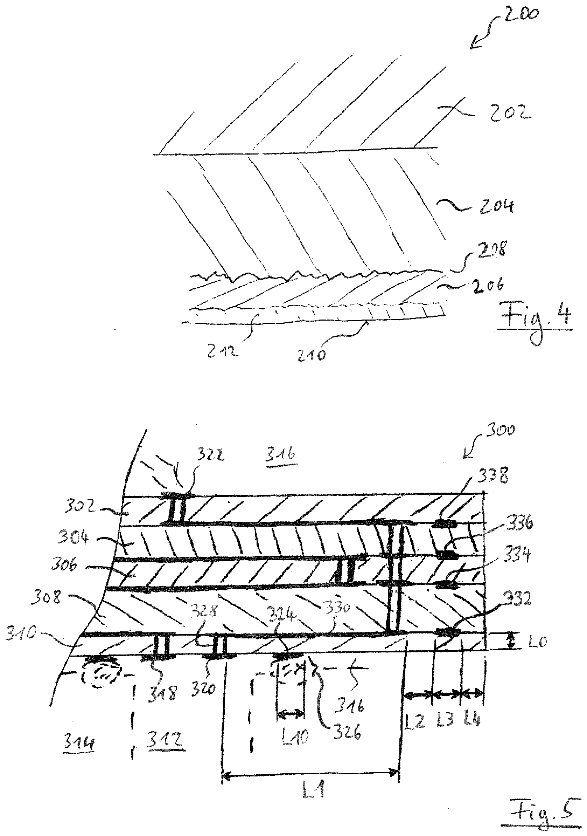

In Fig. 4 ist eine Auflage 200 für ein Dichtelement gezeigt, welche auf einer Außenseite der hier nicht näher dargestellten Platine angeordnet ist. Der Aufbau der Auflage 108 der Platine 100 der Fig. 2 und 3 kann beispielsweise dem im Folgenden näher beschriebenen Aufbau der Auflage 200 entsprechen.

Die Auflage 200 umfasst eine erste Kupferschicht 202, die unmittelbar auf eine hier ebenfalls nicht näher dargestellte Trägerschicht der Platine aufgebracht ist und in ihrer Form durch Ätzen ausgebildet ist. Eine zweite Kupferschicht 204 ist beispielsweise elektrolytisch oder galvanisch auf die erste Kupferschicht 202 aufgebracht.

Eine Nickelschicht 206 ist auf die zweite Kupferschicht 204 aufgebracht, wobei jedoch vor dem Aufbringen der Nickelschicht 206 eine Kontaktfläche 208 der zweiten Kupferschicht 204 geebnet wurde, um die mechanische Verbindung zwischen der zweiten Kupferschicht 204 und der Nickelschicht 206 zu verbessern.

Eine Auflagefläche 210 für ein Dichtelement wird durch eine dünne Goldschicht 212 gebildet, die auf die Nickelschicht 206 aufgebracht ist.

In Fig. 5 ist eine Platine 300 gezeigt, die fünf Lagen von Trägerschichten 302, 304, 306, 308 und 310 aufweist. Die Platine 300 trennt einen Vakuumbereich 312, der in einem angedeuteten Gehäuse 314 definiert ist, von einem Druckbereich 316. In dem Vakuumbereich 312 befinden sich zwei Kontaktpunkte 318 und 320 der Platine 300, die mit Kontaktpunkten der Platine 300 im Druckbereich 316 verbunden sind. In der teilweisen Darstellung der Fig. 5 ist sichtbar, dass der Kontaktpunkt 320 über mehrere Durchkontaktierungen und innenliegende Leiter mit dem Kontaktpunkt 322 verbunden ist und so eine elektrische Kontaktierung zwischen dem Vakuumbereich 312 und dem Druckbereich 316 ermöglicht.

Die Platine 300 weist eine Auflage 324 auf, über welche die Platine 300 einen O-Ring 326 gegen das Gehäuse 314 komprimiert. Dabei bildet sich zwischen der Auflage 324 und dem O-Ring 326 aufgrund von dessen Elastizität eine Kontaktfläche aus, die quer zum O-Ring 326 eine Länge L10 aufweist, die auch als Dichtlänge bezeichnet wird, da sie die Länge eines Fluidpfades in der Dichtung beschreibt. Die Dichtlänge L10 bildet dabei eine direkte Verbindung zwischen dem Vakuumbereich 312 und dem Druckbereich 316. Sie lässt sich jedoch, beispielsweise mit einer Auflage gemäß Fig. 4, sehr gut abdichten.

Neben der Dichtlänge L10 bzw. der O-Ringdichtung 326 besteht auch ein Fluidpfad, der durch die Platine 300 verläuft, und zwar entlang der Durchkontaktierungen und innenliegenden Leiter aufgrund von Unvollkommenheiten in der Verbindung des leitenden Kupfers mit den Trägerschichten 302 bis 310 der Platine 300. Außerdem bestehen Unvollkommenheiten in der Verbindung zwischen den einzelnen Trägerschichten 302 bis 310, so dass zwischen zwei jeweiligen Trägerschichten von einem Leiter bzw. einer Durchkontaktierung hin zu einem Rand der Platine ein weiterer möglicher Fluidpfad besteht.

Für eine unmittelbar mit dem Kontaktpunkt 320 verbundene Durchkontaktierung 328 und einen Leiter 330 besteht also ein Fluidpfad entlang der Durchkontaktierung 328 bzw. entlang einer Dichtlänge L0, entlang des Leiters 330 bzw. entlang einer Dichtlänge L1 und weiter zwischen den Trägerschichten 308 und 310 hin zu einem Rand der Platine 300 bzw. entlang von Dichtlängen L2, L3 und L4. Diesen wie auch andere Fluidpfade in der Platine 300 gilt es durch ein möglichst optimales Umschließen der Leiter und Durchkontaktierungen durch die Trägerschichten bzw. eine möglichst optimale Verbindung zwischen den Trägerschichten abzudichten.

Zur Verbesserung der Abdichtung des zuvor beschriebenen Fluidpfades L0 bis L4 ist ein Blindleiter 332, also ein nicht beschalteter Leiter, vorgesehen. Der Blindleiter 332 verläuft dabei zumindest teilweise um den Leiter 330 herum, was jedoch in der gewählten Schnittdarstellung der Fig. 5 nicht sichtbar ist. Zur verbesserten Abdichtung weiterer Grenzflächen zwischen jeweiligen Trägerschichten 302 bis 308 sind weitere Blindleiter 334, 336 und 338 vorgesehen.

Zur Erzielung einer möglichst kompakt bauenden und ausreichend dichten erfindungsgemäßen Platine als Vakuumdurchführung ist es sinnvoll, eine detaillierte Kalkulation und Abstimmung aller effektiven Fluidpfade innerhalb der Platine auszuführen. Diese Kalkulation kann in Form einer Netzwerkberechnung oder Netzwerkanalyse analog der in der Elektrotechnik üblichen Vorgaben erfolgen. Hierbei stellen sich die Fluidpfade als elektrische Leiter, längen- und elementspezifische Dichtigkeiten von Elementen oder Fluidpfaden als absoluter oder spezifischer elektrischer Widerstand, Druckunterschiede zwischen verschiedenen Orten als elektrische Gleichspannung oder Potential und entstehende Gasflüsse zwischen Orten oder auf Fluidpfaden als elektrische Ströme dar. Sämtliche Elemente lassen sich als Netzwerk aus Reihen-, Parallel- und Gruppenschaltungen betrachten, womit die Regeln der Elektrotechnik zur Berechnung von elektrischen Netzwerken Anwendung finden können, beispielhaft seien hier Kirchhoffsche Regeln, Zweigstromanalyse, Überlagerungsverfahren nach Helmholtz, Maschenstromverfahren und Knotenpotentialverfahren genannt.

Eine optimal ausgelegte Platine zeichnet sich durch möglichst geringe Baugröße und damit Leiterlängen bei gleichzeitig bestmöglicher Dichtheit aus. Hierfür erweist es sich als vorteilhaft, die Einzeldichtigkeiten der Fluidpfade so abzustimmen, dass kein Pfad unvorteilhaft übermäßig undicht, also beispielsweise zu kurz oder unvorteilhaft übermäßig dicht, also beispielsweise zu lang, ausgeführt wird.

Ein beispielhaftes Netzwerk kann auf Basis der Platine 100 in Fig. 2 und Fig. 3 aufgestellt werden. Die erste Gruppe dreier zueinander parallel geschalteter Fluidpfade beginnt an den drei Kontaktpunkten 106 mit anliegendem Umgebungsdruck im Druckbereich 128. Von dort verlaufen die drei Pfade jeweils in Reihenschaltung über die Durchkontaktierung durch die Trägerschicht 118 hindurch entlang der drei Leiter 104 jeweils mit spezifischen Dichtheiten über ihre Länge bis zu den Durchkontaktierungen durch die Trägerschicht 120 hindurch und enden an den Kontaktpunkten 102 auf Vakuumdruck im Vakuumbereich 126.

Eine zweite Gruppe von Fluidpfaden befindet sich im Bereich der Auflage 108, hier existieren mehrere parallel geschaltete Pfade zwischen und durch die Materialschichten der Trägerschicht 120, der Auflage 108, des O-Rings 116 und des Gehäuses 112, die jeweils an ihren beiden gegenüberliegenden Seiten im Druckbereich 128 beginnen und im Vakuumbereich 126 enden. Die Fluidpfade sind im Bereich des O-Rings 116 nicht lang, jedoch sehr breit. Die Länge des Fluidpfades zwischen Auflage 108 und O-Ring 116 ist zum Beispiel gemäß Fig. 5 mit der Dichtlänge L10 definiert, die Breite bzw. Dichtbreite kann mit dem mittleren Umfang der Auflage 108 annähernd beschrieben werden.

Eine letzte, dritte Gruppe von Fluidpfaden stellt bereits in sich ein komplexes Netzwerk dar, das seinen Beginn auf der von der Auflage 108 eingeschlossenen Oberfläche der Trägerschicht 120 nimmt. Ein Teilpfad kann auf Basis der spezifischen Dichtigkeiten des Materials der Trägerschichten 118 und 120 mit einer zwischenliegenden Verklebung gebildet werden, hierbei gehen die Wandstärken der Trägerschichten und die gesamte eingeschlossene Oberfläche im Auflagering 108 als Variablen ein. Ein weiterer Teilpfad entsteht entlang der Durchkontaktierung zwischen Kontaktpunkt 102 und Leiter 104 mit der Dicke der Trägerschicht 120 als Länge, dieser Pfad setzt sich durch die Wandstärke der Trägerschicht 118 hindurch gemäß vorigen Ausführungen fort. Ein weiterer Pfad setzt sich zwischen den Trägerschichten im Bereich der Verklebung auf kürzestmöglichem Weg zu den Rändern der Trägerschichten fort.

Die drei genannten Gruppen von Fluidpfaden können im Gesamtnetzwerk vereinfacht als parallel geschaltet bzw. funktional parallel verlaufend betrachtet werden, bei näherer Betrachtung beeinflussen sich diese jedoch zumindest teilweise auch untereinander, zum Beispiel die erstgenannten Fluidpfade vorwiegend im Bereich der Durchkontaktierung unter dem Kontaktpunkt 102 mit den letztgenannten. Aus den Gesamtberechnungen aller Leckagen kann eine Gesamtdichtigkeit des Bereichs "Gehäuse mit Platine" ermittelt und gegen den Bedarf abgeprüft werden.

Mit Hilfe der Netzwerkberechnung können Fluidpfade identifiziert werden, die übermäßig undicht oder dicht gegenüber anderen Pfaden sind. Durch konstruktive Anpassung können diese Bereiche dichter oder kompakter bzw. einfacher ausgeführt werden, so dass nach einer Optimierung gemäß der Netzwerkberechnung alle Fluidpfade der Platine zumindest ähnlich dicht ausgeführt werden, um eine effiziente Gesamtlösung zu erzielen.

Im Beispiel der Platine 100 aus Fig. 2 wird im einfachsten Fall nach einer Optimierung der mittlere der drei Leiter 104 kürzer ausgeführt werden, da dieser wie dargestellt durch seine relativ größere Länge entlang des Fluidpfads eine unnötig durchschnittlich höhere Dichtigkeit gegenüber seinen beiden benachbarten Leitern erzielen würde.

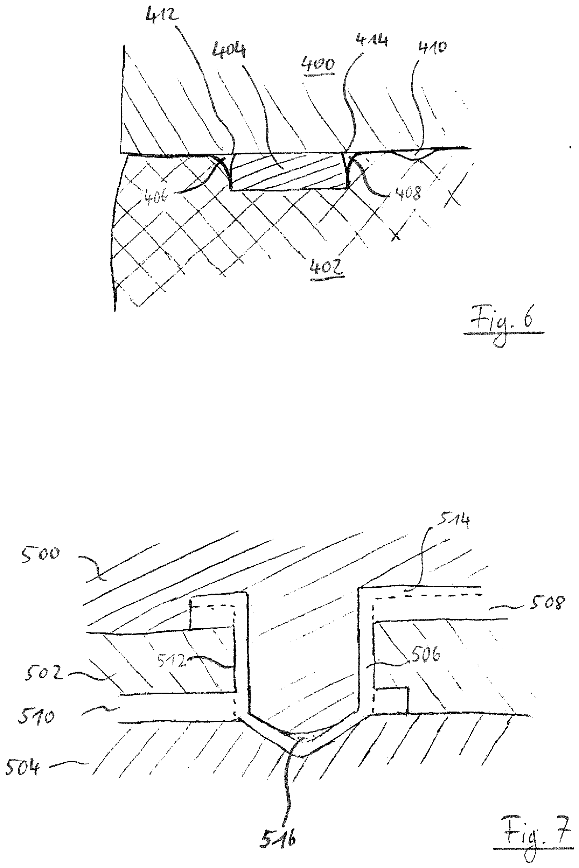

In Fig. 6 sind zwei Trägerschichten 400 und 402 einer hier nur teilweise dargestellten Platine in einer Schnittansicht gezeigt, die einen innenliegenden Leiter 404 einbetten. Der Leiter 404 wurde durch Ätzen von einer Rohplatine, welche die Trägerschicht 400 bildet, ausgebildet. Die Trägerschicht 402 wurde hingegen auf die Trägerschicht 400 nach Ausbilden des Leiters 404 bzw. nach dem Ätzen aufgebracht. Die Trägerschicht 402 umfasst ein beim Aufbringen relativ zähfließendes Material, wie zum Beispiel ein Epoxidharz, welches sich an den Leiter 404 und an die Trägerschicht 400 anschmiegt, wobei jedoch Unvollkommenheiten bzw. Fehlstellen 406, 408 und 410 verbleiben. Eine glatte, der Trägerschicht 402 zugewandte Oberfläche des Leiters 404 wird dagegen beim Aufbringen der Trägerschicht 402 meist relativ gleichmäßig verbunden. Es bilden sich also vornehmlich Fehlstellen 406 und 408 an den Seiten des Leiters 404 und Fehlstellen 410 zwischen den Trägerschichten 402 und 400 aus. Dabei wird das Problem der Fehlstellen 406 und 408 dadurch verschärft, dass beim Ätzen des Leiters 404 häufig am Grund des Leiters Hinterschneidungen 412 und 414 ausgebildet werden, welche die Fehlstellen 406 und 408 vergrößern und besonders schwierig zu verfüllen sind. Beispielsweise kann daher gemäß der Erfindung vorgesehen sein, die Trägerschicht 402 unter erhöhtem Druck und/oder erhöhter Temperatur auf die Trägerschicht 400 aufzubringen.

Wie aus Fig. 6 ersichtlich ist der Widerstand für ein abzudichtendes Fluid besonders in einer Richtung entlang des Leiters durch die Fehlstellen 406 und 408, also senkrecht zur Bildebene, gering. Der Fluidpfad entlang des Leiters 404 lässt sich also nur schwierig abdichten. Beispielsweise kann erfindungsgemäß der Leiter 404 bzw. der entsprechende Fluidpfad deshalb besonders lang und/oder komplex ausgebildet sein, um so den Gesamtwiderstand des Fluidpfades bzw. dessen Dichtigkeit zu erhöhen.

Dagegen ist der Widerstand für Fluid in einer Richtung quer zum Leiter 404, in Fig. 6 horizontal, relativ groß, da beide Kontaktflächen des Leiters 404 mit den Trägerschichten 400 und 402 relativ gleichmäßig und vollkommen ausgebildet werden können. Es ist also ersichtlich, dass sowohl beschaltete als auch nicht beschaltete Leiter eine gute Abdichtung zwischen zwei Trägerschichten 400 und 402 quer zu diesem Leiter bilden können. Durch Anordnung von beschalteten und nicht beschalteten Leitern können also insbesondere gezielt bestimmte Bereiche der Platine zwischen den Trägerschichten abgedichtet werden.

In Fig. 7 sind drei Trägerschichten 500, 502 und 504 einer Platine gezeigt, wobei zwischen zwei Kontaktflächen jeweils zweier benachbarter Trägerschichten 500, 502, 504 eine Durchkontaktierung 506 zur Verbindung von zwei Leitern 508 und 510 vorgesehen ist.

Die Platine der Fig. 7 wird hergestellt, indem die Trägerschicht 504 zunächst vollständig mit Kupfer beschichtet wird. Eine solche beschichtete Trägerschicht kann auch als Rohplatine zur Verfügung gestellt werden. Anschließend wird der Leiter 510 aus der Kupferbeschichtung der Trägerschicht 504 geätzt. Anschließend wird die Trägerschicht 502 auf die Trägerschicht 504 und den Leiter 510 aufgebracht.

Um den Leiter 508 auszubilden, wird die Trägerschicht 502 ebenso mit Kupfer vollständig beschichtet und der Leiter 508 wird geätzt. Dann wird die Durchkontaktierung 506 hergestellt, indem eine Bohrung 512 in Fig. 7 von oben durch den Leiter 508 und den Leiter 510 eingebracht wird. Anschließend wird eine zusätzliche Kupferschicht 514 elektrolytisch oder galvanisch in der Bohrung 512 und an Kontaktflächen zu den Leitern 508 und 510 abgeschieden. Die Trägerschicht 500 wird unter erhöhter Temperatur und/oder erhöhtem Druck auf die Trägerschicht 502 und den Leiter 508 aufgebracht bzw. in die Durchkontaktierung 506 eingebracht, so dass ein Trägermaterial der Trägerschicht 500 die Durchkontaktierung 506 möglichst vollständig verfüllt. Jedoch können auch hier Fehlstellen 516, insbesondere am Grund der Bohrung 512 bzw. der Durchkontaktierung 506 verbleiben.

In der Ausführungsform der Fig. 7 durchdringt die Bohrung 512 beide Leiter 508 und 510 vollständig. Gemäß einer alternativen Ausführungsform, die nicht separat gezeigt ist, kann vorgesehen sein, dass die Bohrung 512 den Leiter 510 nicht oder nicht vollständig durchdringt. So lässt sich die Dichtigkeit im Bereich der Durchkontaktierung 506 weiter erhöhen.

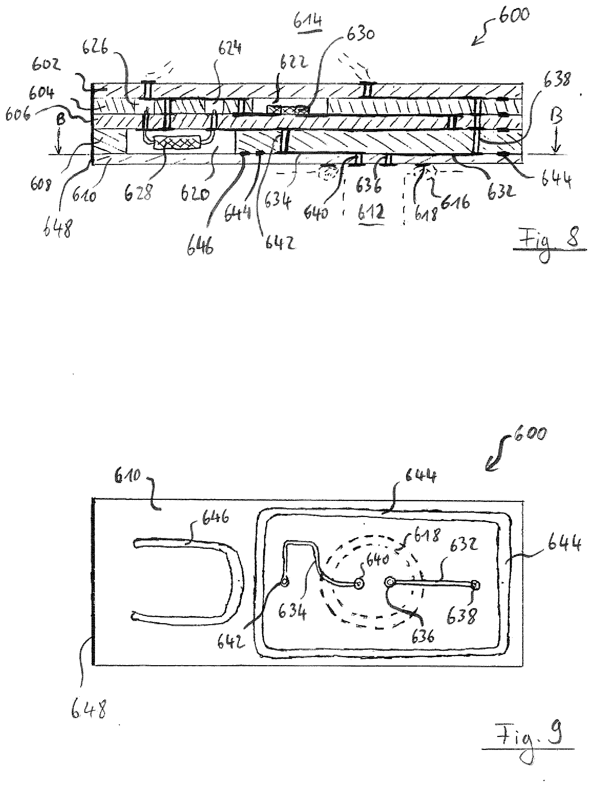

In Fig. 8 ist eine weitere Platine 600 mit fünf Trägerschichten 602, 604, 606, 608 und 610 gezeigt. Die Platine 600 trennt einen Vakuumbereich 612 von einem Druckbereich 614 und komprimiert einen O-Ring 616 über eine Auflage 618.

Die Platine 600 weist mehrere Kavitäten 620, 622, 624 und 626 auf, die in dieser Ausführungsform als Hohlräume ausgebildet sind, aber auch, beispielsweise zur weiteren Verbesserung der Dichtwirkung der Platine 600, verfüllt sein können. In den Kavitäten sind elektrische Bauelemente 628 und 630 angeordnet.

In Fig. 9 ist die Platine 600 in einem Schnitt entlang einer Schnittebene B-B gezeigt. Die Schnittebene B-B verläuft entlang einer Grenzfläche zwischen den Trägerschichten 608 und 610. Da die Ansicht der Fig. 9 einer Ansicht in Fig. 8 von oben entspricht, ist lediglich die Trägerschicht 610 sichtbar.

Entlang der Trägerschicht 610 verlaufen zwei innenliegende Leiter 632 und 634, die jeweils Durchkontaktierungen 636 und 638 bzw. 640 und 642 verbinden. Um die Durchkontaktierungen 636 und 640 herum erstreckt sich die in Fig. 9 gestrichelt angedeutete Auflage 618.

Um die Leiter 632 und 634 herum erstreckt sich ein Blindleiter 644, der die Leiter 632 und 634 in ihrer Ebene vollständig umschließt, um den Bereich der Leiter 632 und 634 abzudichten.

Zur Abdichtung der Kavität 620 ist ein weiterer Blindleiter 646 vorgesehen, der die Kavität 620 teilweise umschließt. Außerdem weist die Platine 600 eine Randdichtung 648 auf, welche den in den Fig. 8 und 9 linken Bereich der Platine 600 weiter abdichtet.

Es zeigt sich, dass durch die beschriebenen Maßnahmen, insbesondere durch optimale Gestaltung von beschalteten und nicht beschalteten Leitern in einer mehrlagigen Platine, die Dichtheit der Platine erheblich verbessert werden kann und diese in einer Vakuumanwendung als gut abdichtendes Trennelement verwendet werden kann. Hierdurch sind insbesondere keine zusätzlichen Trennelemente mit elektrischer Leitungsdurchführung notwendig.

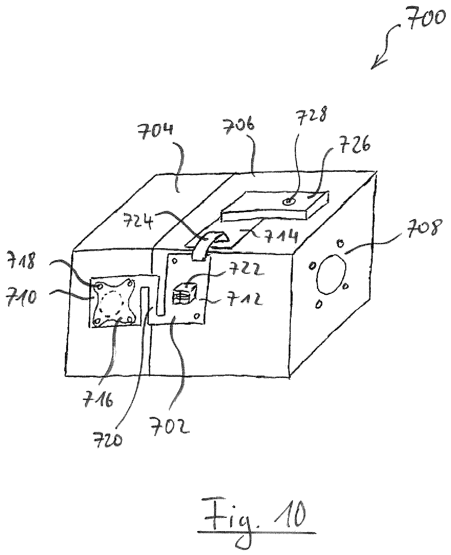

In Fig. 10 ist ein erfindungsgemäßes Vakuumgerät 700 mit einer Platine 702 gezeigt, die als mehrfach wirkendes Trennelement zum Trennen eines Vakuumbereichs von einem Druckbereich ausgebildet ist.

Das Vakuumgerät 700 umfasst ein zweiteiliges Gehäuse 704, 706 mit einem Vakuumflansch 708 zum Anschluss an einen nicht dargestellten VakuumRezipienten bzw. einen Prozessaufbau. Die beiden Gehäuseteile 704, 706 sind zueinander mit einer nicht dargestellten, umlaufenden Dichtung gedichtet. Beide Gehäuseteile weisen elektrische Leitungsdurchführungen zwischen dem innenliegenden Vakuum- und dem umgebenden Druckbereich auf, die mit der mehrere Teilbereiche 710, 712, 714 umfassenden Platine 702 realisiert wird.

Ein erster Teilbereich 710 mit einer als Strichlinie angedeutet dargestellten, zwischen Platine und Gehäuse liegenden Dichtung befindet sich auf der Vorderseite des ersten Gehäuseteils 704. Eine Auflage des ersten Teilbereichs 710 für ein Dichtelement wird durch ein Druckelement 716 mit vier Schrauben 718 durch die Platine 702 hindurch gleichmäßig angepresst. Elektrische Verbindungen werden durch die Platine 702 aus dem innenliegenden Vakuumbereich in nicht dargestellte Leiterbahnen geführt, die über einen mäanderförmig ausgeführten, flexibel verformbaren Verbindungsbereich 720 auf den zweiten Teilbereich 712, der auf der Vorderseite des zweiten Gehäuseteils 706 angeordnet ist, zum elektrischen Anschluss 722 führen.

Eine flexible Ausgestaltung des Verbindungsbereichs ermöglicht den Ausgleich von Höhen- und Ebenheitsunterschieden zwischen den beiden mit Toleranz zueinander gefügten Gehäuseteilen 704, 706, so dass beide Teilbereiche 710, 712 der Platine 702 weitgehend unabhängig voneinander bestmöglich an den Gehäuseteilen 704 bzw. 706 anliegen können.

Der dritte Teilbereich 714 der Platine 702 ist auf der Oberseite des zweiten Gehäuseteils 706 angeordnet und mit einem flexiblen Flachkabel 724 elektrisch mit dem zweiten Teilbereich 712 der Platine 702 verbunden.

Ein nicht dargestellter Dichtbereich zwischen drittem Teilbereich 714 und dem zweiten Gehäuseteil 706 unter einem Druckelement 726, welches mit einer außerhalb der Platine 702 liegenden Schraube 728 vorgespannt wird, führt weitere elektrische Verbindungen aus dem Vakuumbereich auf die Platine 702 und über die flexiblen Leiter des Flachkabels 724 zum elektrischen Anschluss 722 auf dem zweiten Teilbereich 712 der Platine 702.

Unter dem Druckelement 726 liegt gegenüber der Platine 702 ein weiterer Dichtbereich, der eine nicht dargestellte Wartungsöffnung im Gehäuseteil 706 direkt mit einer Dichtung verschließt. Die Vorspannkräfte der Dichtungen der Wartungsöffnung und der Dichtung zwischen dem dritten Teilbereich 714 der Platine 702 und dem zweiten Gehäuseteil 706 werden gemeinsam durch die zentral angeordnete Schraube 728 aufgebracht, das Druckelement 726 wirkt hier als verteilendes und ausgleichendes Element.

### Bezugszeichenliste

- 10: Vakuumpumpe
- 12: Einlassflansch
- 14: Pumpeneinlass
- 16: Gehäuse
- 18: Rotationsachse
- 20: Rotorwelle
- 22: Rotorscheibe
- 24: Statorscheibe
- 26: Distanzring
- 28: Schöpfbereich
- 30: Pfeil
- 32: Rotornabe
- 34: Holweck-Rotorhülse
- 36: Holweck-Rotorhülse
- 38: Holweck-Statorhülse
- 40: Holweck-Statorhülse
- 42: Wälzlager
- 44: Permanentmagnetlager
- 46: rotorseitige Lagerhälfte
- 48: statorseitige Lagerhälfte
- 50: permanentmagnetischer Ring
- 52: permanentmagnetischer Ring
- 54: radialer Lagerspalt
- 56: Not- oder Fanglager
- 58: konische Spritzmutter
- 60: saugfähige Scheibe
- 62: Antriebsmotor
- 64: Steuerungseinheit
- 66: Motorstator
- 68: Leiter
- 70: Gang
- 72: Gehäuseteil
- 74: Platine
- 78: O-Ring
- 80: Druckbereich
- 82: Vakuumbereich
- 84: Schraube

- 100: Platine
- 102: Kontaktpunkt
- 104: Leiter
- 106: Kontaktpunkt
- 108: Auflage
- 110: Bohrung
- 112: Gehäuse
- 114: Schraube
- 116: O-Ring
- 118: Trägerschicht
- 120: Trägerschicht
- 122: Anschlussleiter
- 124: Anschlussleiter
- 126: Vakuumbereich
- 128: Druckbereich

- 200: Auflage
- 202: erste Kupferschicht
- 204: zweite Kupferschicht
- 206: Nickelschicht
- 208: Kontaktfläche
- 210: Auflagefläche
- 212: Goldschicht

- 300: Platine
- 302: Trägerschicht
- 304: Trägerschicht
- 306: Trägerschicht
- 308: Trägerschicht
- 310: Trägerschicht
- 312: Vakuumbereich
- 314: Gehäuse
- 316: Druckbereich
- 318: Kontaktpunkt
- 320: Kontaktpunkt
- 322: Kontaktpunkt
- 324: Auflage
- 326: O-Ring
- 328: Durchkontaktierung
- 330: Leiter
- 332: Blindleiter
- 334: Blindleiter
- 336: Blindleiter
- 338: Blindleiter

- 400: Trägerschicht
- 402: Trägerschicht
- 404: Leiter
- 406: Fehlstelle
- 408: Fehlstelle
- 410: Fehlstelle
- 412: Hinterschneidung
- 414: Hinterschneidung

- 500: Trägerschicht
- 502: Trägerschicht
- 504: Trägerschicht
- 506: Durchkontaktierung
- 508: Leiter
- 510: Leiter
- 512: Bohrung
- 514: Kupferschicht
- 516: Fehlstelle

- 600: Platine
- 602: Trägerschicht
- 604: Trägerschicht
- 606: Trägerschicht
- 608: Trägerschicht
- 610: Trägerschicht
- 612: Vakuumbereich
- 614: Druckbereich
- 616: O-Ring
- 618: Auflage
- 620: Kavität
- 622: Kavität
- 624: Kavität
- 626: Kavität
- 628: elektronische Komponente
- 630: elektronische Komponente
- 632: Leiter
- 634: Leiter
- 636: Durchkontaktierung
- 638: Durchkontaktierung
- 640: Durchkontaktierung
- 642: Durchkontaktierung
- 644: Blindleiter
- 646: Blindleiter
- 648: Randdichtung

- 700: Vakuumgerät
- 702: Platine
- 704: erster Gehäuseteil
- 706: zweiter Gehäuseteil
- 708: Vakuumflansch
- 710: erster Teilbereich
- 712: zweiter Teilbereich
- 714: dritter Teilbereich
- 716: Druckelement
- 718: Schraube
- 720: Verbindungsbereich
- 722: elektrischer Anschluss
- 724: Flachkabel
- 726: Druckelement
- 728: Schraube

## Patentansprüche

1. Vakuumgerät (10, 700), insbesondere Vakuumpumpe, umfassend einen Vakuumbereich (82, 126, 312, 612) und einen Druckbereich (80, 128, 316, 614) und eine Platine (74, 100, 300, 600, 702), die zwischen dem Vakuumbereich und dem Druckbereich angeordnet ist und zwischen diesen ein Trennelement bildet,
wobei die Platine (74, 100, 300, 600, 702) zusammen mit einem Dichtelement (78, 116, 326, 616) eine Dichtung zwischen dem Vakuumbereich (82, 126, 312, 612) und dem Druckbereich (80, 128, 316, 614) bildet, wobei die Platine eine Auflage (108, 200, 324) für das Dichtelement aufweist, welche zumindest eine erste Kupferschicht (202) aufweist, die unmittelbar auf ein Trägermaterial der Platine aufgebracht ist,
**dadurch gekennzeichnet, dass** die Auflage (108, 200, 324) zumindest eine zweite Kupferschicht (204) aufweist, welche elektrolytisch oder galvanisch auf die erste Kupferschicht (202) aufgebracht ist.

2. Vakuumgerät (10) nach Anspruch 1,
**dadurch gekennzeichnet, dass**
zumindest eine Schicht der Auflage (108, 200, 324), insbesondere an einer Verbindungsfläche (208) zu einer weiteren Schicht (206) oder einer Auflagefläche (210) für das Dichtelement (78, 116, 326, 616), insbesondere mechanisch, geebnet und/oder geglättet ist.

3. Vakuumgerät (10, 700) nach Anspruch 1 oder 2,
**dadurch gekennzeichnet, dass**
die Auflage (108, 200, 324) zumindest eine Nickelschicht (206) aufweist.

4. Vakuumgerät (10, 700), nach zumindest einem der vorhergehenden Ansprüche, **dadurch gekennzeichnet, dass** die Platine (74, 100, 300, 600, 702) eine innenliegende Durchkontaktierung (506) aufweist, welche mit einem Kunststoffmaterial verfüllt ist, und dass das Kunststoffmaterial ein Material einer der Durchkontaktierung benachbarten Trägerschicht (500) der Platine ist.

5. Vakuumgerät (10, 700) nach Anspruch 4,
**dadurch gekennzeichnet, dass**
die Durchkontaktierung zumindest im Wesentlichen vollständig verfüllt ist.

6. Vakuumgerät (10, 700) nach Anspruch 4 oder 5,
**dadurch gekennzeichnet, dass**
das Kunststoffmaterial unter erhöhtem Druck und/oder erhöhter Temperatur in die Durchkontaktierung (506) eingebracht worden ist.

7. Vakuumgerät (10, 700) nach zumindest einem Ansprüche 4 bis 6,
**dadurch gekennzeichnet, dass**
die Durchkontaktierung einen ersten Leiter, einen zweiten Leiter und eine die Leiter verbindende Bohrung umfasst, welche zumindest den zweiten Leiter nicht oder nicht vollständig durchdringt.

8. Vakuumgerät (10, 700) nach zumindest einem der vorhergehenden Ansprüche,
**dadurch gekennzeichnet, dass**
die Platine (74, 100, 300, 600, 702) zumindest zwei Trägerschichten (302 - 310, 400, 402, 500 - 504) aufweist und dass zwischen den Trägerschichten eine zusätzliche Dichtung (332 - 338, 644, 648) vorgesehen ist.

9. Vakuumgerät (10, 700) nach Anspruch 8,
**dadurch gekennzeichnet, dass**
die zusätzliche Dichtung als ein, insbesondere nicht beschalteter, Leiter (332 - 338, 644) ausgebildet ist.

10. Vakuumgerät (10, 700) nach zumindest einem der vorhergehenden Ansprüche,
**dadurch gekennzeichnet, dass**
die Platine (600) eine Kavität (620 - 626), insbesondere zur Anordnung elektronischer Komponenten (628, 630), aufweist, wobei insbesondere die Kavität einen abzudichtenden Bereich bildet.

11. Vakuumgerät (10, 700) nach zumindest einem der vorhergehenden Ansprüche,
**dadurch gekennzeichnet, dass**
die Platine (74, 100, 300, 600, 702) wenigstens zwei Trägerschichten aufweist, zwischen denen wenigstens ein Leiter vorgesehen ist, wobei zwischen den Trägerschichten zum Ausgleich von Unebenheiten in der Platine zumindest eine Ausgleichsschicht vorgesehen ist, wobei vorzugsweise die Ausgleichsschicht als, insbesondere nicht beschalteter, Leiter ausgebildet ist.

12. Vakuumgerät (10, 700) nach zumindest einem der vorhergehenden Ansprüche,
**dadurch gekennzeichnet, dass**
in der Platine (74, 100, 300, 600, 700) wenigstens zwei funktional parallele Fluidpfade vorhanden sind, die zumindest teilweise entlang innenliegender Leiter in der Platine verlaufen, wobei die zwei Fluidpfade wenigstens annähernd gleiche Teildichtigkeiten aufweisen.

## Claims

1. A vacuum device (10, 700), in particular a vacuum pump, comprising a vacuum region (82, 126, 312, 612); a pressure region (80, 128, 316, 614); and a circuit board (74, 100, 300, 600, 702) which is arranged between the vacuum region and the pressure region and forms a separating element between them,
wherein the circuit board (74, 100, 300, 600, 702) together with a sealing element (78, 116, 326, 616) forms a seal between the vacuum region (82, 126, 312, 612) and the pressure region (80, 128, 316, 614), wherein the circuit board comprises a support (108, 200, 324) for the sealing element, said support (108, 200, 324) having at least a first copper layer (202) which is applied directly to a carrier material of the circuit board,
**characterized in that**
the support (108, 200, 324) has at least a second copper layer (204) which is electrolytically or galvanically applied to the first copper layer (202).

2. A vacuum device (10) in accordance with claim 1,
**characterized in that**
at least one layer of the support (108, 200, 324), in particular at a connection surface (208) to a further layer (206) or a support surface (210) for the sealing element (78, 116, 326, 616), is leveled and/or smoothed, in particular mechanically leveled and/or smoothed.

3. A vacuum device (10, 700) in accordance with claim 1 or claim 2,
**characterized in that**
the support (108, 200, 324) has at least one nickel layer (206).

4. A vacuum device (10, 700) in accordance with at least one of the preceding claims, **characterized in that** the circuit board (74, 100, 300, 600, 702) has an inwardly disposed via (506) which is filled with a plastic material; and **in that** the plastic material is a material of a carrier layer (500) of the circuit board adjacent to the via.

5. A vacuum device (10, 700) in accordance with claim 4,
**characterized in that**
the via is at least substantially completely filled.

6. A vacuum device (10, 700) in accordance with claim 4 or claim 5,
**characterized in that**
the plastic material has been introduced into the via (506) under elevated pressure and/or at an elevated temperature.

7. A vacuum device (700) in accordance with any one of the claims 4 to 6,
**characterized in that**
the via comprises a first conductor; a second conductor; and a bore which connects the conductors and which does not or does not completely penetrate at least the second conductor.

8. A vacuum device (10, 700) in accordance with at least one of the preceding claims,
**characterized in that**
the circuit board (74, 100, 300, 600, 702) has at least two carrier layers (302 - 310, 400, 402, 500 - 504); and **in that** an additional seal (332 - 338, 644, 648) is provided between the carrier layers.

9. A vacuum device (10, 700) in accordance with claim 8,
**characterized in that**
the additional seal is configured as a conductor (332 - 338, 644), in particular a non-connected conductor.

10. A vacuum device (10, 700) in accordance with at least one of the preceding claims,
**characterized in that**
the circuit board (600) has a cavity (620 - 626), in particular for the arrangement of electronic components (628, 630), with in particular the cavity forming a region to be sealed.

11. A vacuum device (10, 700) in accordance with at least one of the preceding claims,
**characterized in that**
the circuit board (74, 100, 300, 600, 702) has at least two carrier layers between which at least one conductor is provided, with at least one levelling layer being provided between the carrier layers to compensate unevenness in the circuit board, with preferably the levelling layer being configured as a conductor, in particular a non-connected conductor.

12. A vacuum device (10, 700) in accordance with at least one of the preceding claims,
**characterized in that**
at least two functionally parallel fluid paths are present in the circuit board (74, 100, 300, 600, 700) and extend at least partly along inwardly disposed conductors in the circuit board, with the two fluid paths having at least approximately equal part tightnesses.

## Revendications

1. Appareil à vide (10, 700), en particulier pompe à vide, comprenant une zone de vide (82, 126, 312, 612) et une zone de pression (80, 128, 316, 614) et une platine (74, 100, 300, 600, 702) qui est disposée entre la zone de vide et la zone de pression et qui constitue un élément de séparation entre celles-ci,
dans lequel
la platine (74, 100, 300, 600, 702) constitue, conjointement avec un élément d'étanchéité (78, 116, 326, 616), un joint d'étanchéité entre la zone de vide (82, 126, 312, 612) et la zone de pression (80, 128, 316, 614), la platine présentant un support (108, 200, 324) pour l'élément d'étanchéité, lequel support présente au moins une première couche de cuivre (202) qui est appliquée directement sur un matériau porteur de la platine,
**caractérisé en ce que**
le support (108, 200, 324) présente au moins une seconde couche de cuivre (204) qui est appliquée par voie électrolytique ou galvanique sur la première couche de cuivre (202).

2. Appareil à vide (10) selon la revendication 1,
**caractérisé en ce que**
au moins une couche du support (108, 200, 324), en particulier au niveau d'une surface de raccordement (208) à une autre couche (206) ou d'une surface de support (210) pour l'élément d'étanchéité (78, 116, 326, 616), est rendue plane et/ou lissée, en particulier mécaniquement.

3. Appareil à vide (10, 700) selon la revendication 1 ou 2,
**caractérisé en ce que**
le support (108, 200, 324) présente au moins une couche de nickel (206).

4. Appareil à vide (10, 700) selon l'une au moins des revendications précédentes,
**caractérisé en ce que**
la platine (74, 100, 300, 600, 702) présente un via interne (506) qui est rempli d'une matière plastique, et **en ce que**
la matière plastique est un matériau d'une couche porteuse (500), adjacente au via, de la platine.

5. Appareil à vide (10, 700) selon la revendication 4,
**caractérisé en ce que**
le via est rempli au moins sensiblement en totalité.

6. Appareil à vide (10, 700) selon la revendication 4 ou 5,
**caractérisé en ce que**
la matière plastique a été introduite dans le via (506) sous une pression élevée et/ou à une température élevée.

7. Appareil à vide (10, 700) selon l'une au moins des revendications 4 à 6,
**caractérisé en ce que**
le via comprend un premier conducteur, un second conducteur et un trou reliant les conducteurs, lequel trou ne traverse pas ou pas complètement au moins le second conducteur.

8. Appareil à vide (10, 700) selon l'une au moins des revendications précédentes,
**caractérisé en ce que**
la platine (74, 100, 300, 600, 702) présente au moins deux couches porteuses (302 - 310, 400, 402, 500 - 504), et **en ce que** un joint d'étanchéité supplémentaire (332 - 338, 644, 648) est prévu entre les couches porteuses.

9. Appareil à vide (10, 700) selon la revendication 8,
**caractérisé en ce que**
le joint d'étanchéité supplémentaire est réalisé sous forme de conducteur (332 - 338, 644), en particulier non mis en circuit.

10. Appareil à vide (10, 700) selon l'une au moins des revendications précédentes,
**caractérisé en ce que**
la platine (600) présente une cavité (620 - 626), en particulier pour agencer des composants électroniques (628, 630), en particulier la cavité formant une zone à sceller.

11. Appareil à vide (10, 700) selon l'une au moins des revendications précédentes,
**caractérisé en ce que**
la platine (74, 100, 300, 600, 702) présente au moins deux couches porteuses entre lesquelles est prévu au moins un conducteur, au moins une couche de compensation étant prévue entre les couches porteuses pour compenser des irrégularités dans la platine, de préférence la couche de compensation étant réalisée sous forme de conducteur, en particulier non mis en circuit.

12. Appareil à vide (10, 700) selon l'une au moins des revendications précédentes,
**caractérisé en ce que**
au moins deux chemins fluidiques fonctionnellement parallèles sont présents dans la platine (74, 100, 300, 600, 700), qui s'étendent au moins partiellement le long de conducteurs internes dans la platine, les deux chemins fluidiques présentant des étanchéités partielles au moins approximativement égales.
